# EUROPEAN PATENT APPLICATION

(11) **EP 4 618 284 A1**
(43) Date of publication of application: **17.09.2025**
(21) Application number: 24175137.9
(22) Date of filing: 10.05.2024
(51) Int. Cl.: H01M 50/287, H01R 13/24, F21V 23/06, H01M 50/213, H01M 50/247

(54) **SPRING ELASTIC-PIECE ELECTRICALLY-CONDUCTIVE STRUCTURE AND ELECTRICAL DEVICE**

(30) Priority: 11.03.2024 CN 202410273435
(71) Applicant: Sysmax Innovations Co., Ltd., Guangzhou 510520 (CN)
(72) Inventor: LI, Wenjie, Tianhe District, Guangzhou (CN)
(74) Representative: Winter, Brandl - Partnerschaft mbB

(57) **Abstract**

Disclosure is a spring elastic-piece electrically-conductive structure and an electrical device. The structure includes a metal elastic piece and a spring. One end of the metal elastic piece is bent relative to another end to form an accommodation space having an opening; the spring is arranged inside the accommodation space, two ends of the spring are connected to the metal elastic piece to support the opening. Besides the spring structure, the metal elastic piece is further included. The metal elastic piece is bent to accommodate the spring. Due to the longer metal wire and higher internal resistance of the spring and the resistance of the metal elastic piece is smaller than that of the spring, most of the current flows through the metal elastic piece with lower internal resistance during operating the electrical device, thereby reducing internal resistance and achieving the goal of reducing heating and power loss.

## Description

### FIELD OF THE DISCLOSURE

The present disclosure relates to the technical field of spring elastic-piece electrically-conductive structures, in particular to a spring elastic-piece electrically-conductive structure and an electrical device.

### BACKGROUND

At present, in most of metal-shell battery-replaceable electrical devices on the market, a contact, an elastic piece, or a spring is connected to a negative electrode of a battery to conduct current to a metal tail cover, the current is conducted to flow to a metal cylinder by an end-surface contact, and then the current flows back to a positive electrode of the battery by a spring elastic-piece electrically-conductive structure and a working circuit, so as to form a closed conductive circuit. The most common negative-electrode spring elastic-piece electrically-conductive structure is arranged with a copper conical spring cooperating with the metal tail cover.

In order to ensure that the spring has sufficient rigidity and elasticity to meet the needs of limiting and electric conducting, a conical spring with a larger number of turns is generally used. However, due to the small contact surface of the conical spring, the long metal wire of the spring, and the high internal resistance, the power loss caused by the internal resistance of the spring is also high.

Therefore, the prior art still needs to be improved and developed.

### BRIEF SUMMARY OF THE DISCLOSURE

According to the above-mentioned defects of the prior art, the present disclosure provides a spring elastic-piece electrically-conductive structure and an electrical device, aiming to solve the technical problem that the spring elastic-piece electrically-conductive structure in the prior art has high internal resistance and high power loss.

The technical schemes adopted by the present disclosure to solve the above-mentioned technical problem are as follows.

A spring elastic-piece electrically-conductive structure includes:
a metal elastic piece; one end of the metal elastic piece is bent relative to another end of the metal elastic piece to form an accommodation space having an opening; and
a spring, arranged inside the accommodation space; two ends of the spring are connected to the metal elastic piece to support the opening.

In one implementation, the metal elastic piece includes:
a first metal elastic piece;
a second metal elastic piece; one end of the second metal elastic piece is connected to the first metal elastic piece, and is inclined relative to the first metal elastic piece; and
a third metal elastic piece; one end of the third metal elastic piece is connected to one end of the second metal elastic piece away from the first metal elastic piece, another end of the third metal elastic piece is inclined relative to both the second metal elastic piece and the first metal elastic piece, and the opening is formed between the another end of the third metal elastic piece and the first metal elastic piece; the third metal elastic piece, the second metal elastic piece, and the first metal elastic piece are enclosed to form the accommodation space; the first metal elastic piece, the second metal elastic piece, and the third metal elastic piece are integrally formed.

In one implementation, the first metal elastic piece is a sector metal elastic piece.

In one implementation, a center of a circle of the sector metal elastic piece is located at a central axis of the spring to coincide.

In one implementation, an angle between the second metal elastic piece and the first metal elastic piece is an acute angle, and an angle between the second metal elastic piece and the third metal elastic piece is an obtuse angle.

In one implementation, the second metal elastic piece includes a first elastic piece, a second elastic piece, and a third elastic piece sequentially connected to form a wave shape; the first elastic piece is connected to the first metal elastic piece, and the third elastic piece is connected to the third metal elastic piece; an angle between the second elastic piece and the first elastic piece is greater than an angle between the first elastic piece and the first metal elastic piece, and less than an angle between the third elastic piece and the third metal elastic piece.

In one implementation, the angle between the second elastic piece and the first elastic piece is a right angle.

In one implementation, the metal elastic piece further includes:
a fourth metal elastic piece; one end of the fourth metal elastic piece is connected to the third metal elastic piece, and another end of the fourth metal elastic piece is inclined toward the opening relative to the third metal elastic piece.

An electrical device includes the above-mentioned spring elastic-piece electrically-conductive structure.

In one implementation, the electrical device further includes:
a metal accommodation cylinder, configured to accommodate a battery;
a tail cover, detachably connected to one end of an axial direction of the metal accommodation cylinder; the spring elastic-piece electrically-conductive structure is arranged inside the tail cover, and electrically contacts or connects with the metal accommodation cylinder;
a circuit board, detachably arranged at another end of the axial direction of the metal accommodation cylinder, and electrically connected to the metal accommodation cylinder; and
a positive-electrode electrically-conductive component, arranged on the circuit board, and arranged opposite to the spring elastic-piece electrically-conductive structure.

In the present disclosure, in addition to having the structure of the spring, the metal elastic piece is further included, and the metal elastic piece is in a bent structure to accommodate the spring. Due to the longer metal wire and higher internal resistance of the spring, and the resistance of the metal elastic piece is smaller than the resistance of the spring, most of the current flows through the metal elastic piece with lower internal resistance during operating the electrical device, thereby reducing internal resistance and achieving the goal of reducing heating and power loss.

### BRIEF DESCRIPTION OF THE DRAWINGS

FIG. 1 is a first view of an overall structure of a spring elastic-piece electrically-conductive structure in the present disclosure.
FIG. 2 is a schematic diagram of a structure of a metal elastic piece in the present disclosure.
FIG. 3 is a second view of an overall structure of a spring elastic-piece electrically-conductive structure in the present disclosure.
FIG. 4 is a schematic diagram of an assembly structure of an electrical device in the present disclosure.
FIG. 5 is a schematic diagram of a breakdown structure of an electrical device in the present disclosure.

### DETAILED DESCRIPTION OF EMBODIMENTS

In order to make the purposes, technical schemes, and effects of the present disclosure clearer and more explicit, the present disclosure is further described in detail below with reference to the accompanying drawings and embodiments. It should be understood that the specific embodiments described here are only intended to explain the present disclosure and are not intended to limit the present disclosure.

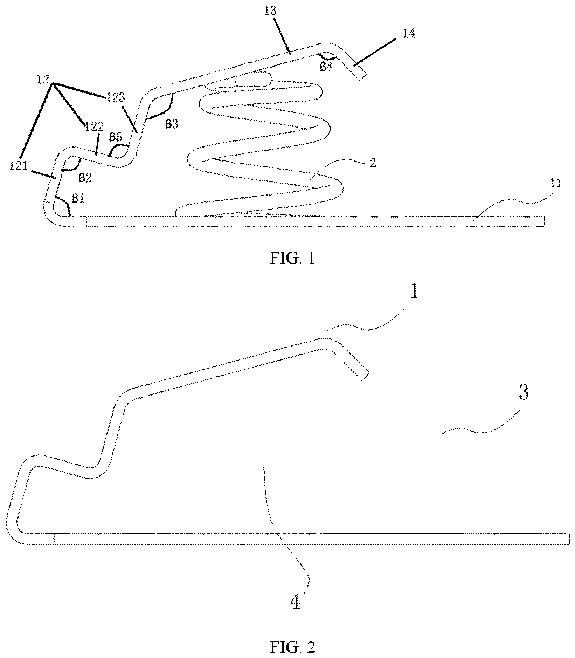

The present disclosure provides a spring elastic-piece electrically-conductive structure, as shown in FIGs. 1, 2, and 3. The spring elastic-piece electrically-conductive structure includes a metal elastic piece 1 and a spring 2. One end of the metal elastic piece 1 is bent relative to another end of the metal elastic piece 1 to form an accommodation space 4 having an opening 3. The spring 2 is arranged inside the accommodation space 4. Two ends of the spring 2 are connected to the metal elastic piece 1 to support the opening 3.

Compared to the prior art, in addition to having the structure of the spring 2, the metal elastic piece 1 is further included, and the metal elastic piece 1 is in a bent structure to accommodate the spring 2. Due to the longer metal wire and higher internal resistance of the spring 2, and the resistance of the metal elastic piece 1 is smaller than the resistance of the spring 2, most of the current flows through the metal elastic piece 1 with lower internal resistance during operating of the electrical device, thereby reducing internal resistance and achieving the goal of reducing heating and power loss.

Moreover, the spring 2 inside the accommodation space 4 is mainly configured to support the metal elastic piece 1 with the bent structure, and strengthen the supporting performance for the metal elastic piece 1, thereby reducing the requirements for the rigidity and elasticity of the metal elastic piece 1 during electric conducting, improving the strength of the metal elastic piece 1, further reducing the internal resistance of the spring elastic-piece electrically-conductive structure, and effectively avoiding poor contact caused by the metal elastic piece 1 being crushed by a battery.

It should be noted that the metal elastic piece 1 is configured to contact with a negative electrode of a battery, thereby making the spring elastic-piece electrically-conductive structure be a negative-electrode conductive structure.

As shown in FIGs. 1, 3, and 4, the metal elastic piece 1 includes a first metal elastic piece 11, a second metal elastic piece 12, and a third metal elastic piece 13. One end of the second metal elastic piece 12 is connected to the first metal elastic piece 11 and inclined relative to the first metal elastic piece 11. One end of the third metal elastic piece 13 is connected to one end of the second metal elastic piece 12 away from the first metal elastic piece 11. Another end of the third metal elastic piece 13 is inclined relative to both the second metal elastic piece 12 and the first metal elastic piece 11, respectively, and the opening 3 is formed between the first metal elastic piece 11 and the another end of the third metal elastic piece 13.

The second metal elastic piece 12 is located between the first metal elastic piece 11 and the third metal elastic piece 13, and is respectively connected to the first metal elastic piece 11 and the third metal elastic piece 13. The inclined arrangements of the second metal elastic piece 12 and the third metal elastic piece 13 allow the third metal elastic piece 13, the second metal elastic piece 12, and the first metal elastic piece 11 to be enclosed to form the accommodation space 4. One end of the first metal elastic piece 11 away from the second metal elastic piece 12 is a free end, one end of the third metal elastic piece 13 away from the second metal elastic piece 12 is a free end, and the opening 3 is formed between the two free ends.

The first metal elastic piece 11 and the third metal elastic piece 13 are both connected to the spring 2, and the first metal elastic piece 11, the second metal elastic piece 12, and the third metal elastic piece 13 are integrally formed.

In one embodiment of the present disclosure, the spring 2 is a conical spring. A small-diameter end of the spring 2 is connected to the third metal elastic piece 13, and a large-diameter end of the spring 2 is connected to the first metal elastic piece 11. Then, the third metal elastic piece 13 is configured to support and abut against a negative electrode of a battery, thereby making the spring elastic-piece electrically-conductive structure be a negative-electrode conductive structure.

In the present disclosure, the second metal elastic piece 12 is included between the third metal elastic piece 13 and the first metal elastic piece 11, and the third metal elastic piece 13 supports the negative electrode of the battery, then, under the transition and support effects of the second metal elastic piece 12, an inclined angle of the third metal elastic piece 13 relative to the first metal elastic piece 11 can be effectively reduced, thereby improving the conductive contact area between the third metal elastic piece 13 and the negative electrode of the battery, and enhancing the electric-conducting performance of the spring elastic-piece electrically-conductive structure.

In one embodiment of the present disclosure, an angle β1 between the second metal elastic piece 12 and the first metal elastic piece 11 is an acute angle, an angle β3 between the second metal elastic piece 12 and the third metal elastic piece 13 is an obtuse angle, making one end of the second metal elastic piece 12 connected to the third metal elastic piece 13 closer to the accommodation space 4, thereby improving the support performance of the second metal elastic piece 12 on the third metal elastic piece 13, and facilitating a reset of the third metal elastic piece 13 when the battery is removed.

In one embodiment of the present disclosure, the first metal elastic piece 11 is a sector metal elastic piece.

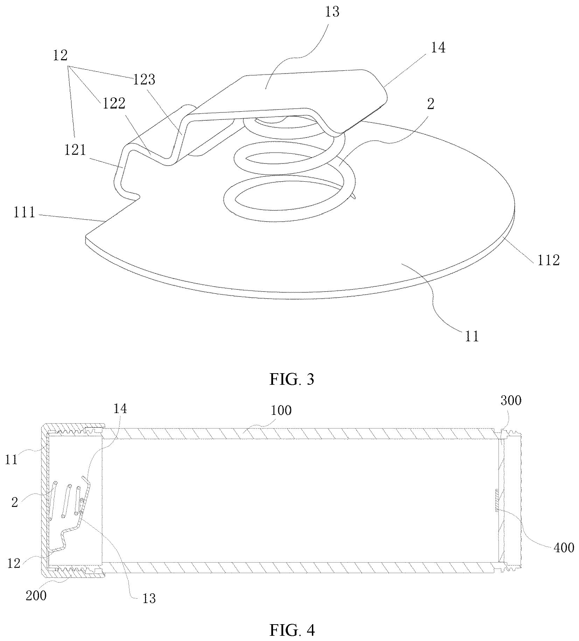

As shown in FIG. 3, an end surface of a periphery of the first metal elastic piece 11 includes a linear end surface 111 and an circular-arc end surface 112. The linear end surface 111 and the circular-arc end surface 112 are connected end-to-end to form a closed-loop structure. The spring elastic-piece electrically-conductive structure in the present disclosure needs to cooperate with a metal accommodation cylinder 100 of the electrical device to form a current circuit. Therefore, in the present embodiment, the first metal elastic piece 11 is arranged as a sector metal elastic piece, so that the circular-arc end surface 112 of the first metal elastic piece 11 can better fit and contact with a cylinder body of the metal accommodation cylinder 100, thereby increasing the contact area between the first metal elastic piece 11 and the metal accommodation cylinder 100, and reducing the contact resistance.

Meanwhile, since the first metal elastic piece 11 is connected to the second metal elastic piece 12 and both are integrated formed, and the second metal elastic piece 12 needs to be bent relative to the first metal elastic piece 11, the linear end surface of the first metal elastic piece 11 in the present embodiment is configured to connect with the second metal elastic piece 12.

In one implementation of the present embodiment, a center of a circle of the sector metal elastic piece is located at a central axis of the spring 2 to coincide, ensuring that the spring 2 can completely contact with the third metal elastic piece 13, thereby providing complete support for the third metal elastic piece 13 through the spring 2, and improving the support performance of the spring 2 on the third metal elastic piece 13.

Meanwhile, when the spring 2 is a conical structure, the central axis of the spring 2 coincides with the center of the circle of the sector metal elastic piece, which can enable the spring 2 to accept more extreme compression and better meet the requirements of elastic support.

In one embodiment of the present disclosure, as shown in FIGs. 1 and 3, the second metal elastic piece 12 is not in a piece-shaped linear structure, but in a wavy-shaped structure with a certain degree of curvature. The second metal elastic piece 12 includes a first elastic piece 121, a second elastic piece 122, and a third elastic piece 123 sequentially connected to form a wave shape. AV-shaped angle is formed between the second elastic piece 122 and the first elastic piece 121, and a V-shaped angle is formed between the second elastic piece 122 and the third elastic piece 123. The openings 3 of the two V-shaped angles (β2 and β5) are oriented in opposite directions and arranged in a staggered manner, thereby forming the wavy-shaped structure for the second metal elastic piece 12. The first elastic piece 121 is not only connected to the second elastic piece 122, but also to the first metal elastic piece 11. The third elastic piece 123 is not only connected to the second elastic piece 122, but also to the third metal elastic piece 13.

In the present embodiment, the wave-shaped structure of the second metal elastic piece 12 makes the second metal elastic piece 12 provide sufficient deformation space for the third metal elastic piece 13 when the third metal elastic piece 13 is compressed and pressed down.

Furthermore, it should be noted that if the second metal elastic piece 12 is a piece-shaped linear structure, when encountering a larger-diameter battery, there may be a phenomenon where a free end of the third metal elastic piece 13 is compressed downward until the free end is lower than one end of the third metal elastic piece 13 connecting to the second metal elastic piece 12, causing only a line contact between the third metal elastic piece 13 and the negative electrode of the battery, thereby resulting in the problem of large resistance. Therefore, in the present embodiment, the second metal elastic piece 12 is a wavy-shaped structure, which can increase the contact area between the third metal elastic piece 13 and the negative electrode of the battery, thereby reducing the resistance.

In one implementation of the present embodiment, when the third metal elastic piece 13 is compressed by the negative electrode of the battery, the angle β1 between the first elastic piece 121 and the first metal elastic piece 11 is a main deformation angle, and the angle β2 between the second elastic piece 122 and the first elastic piece 121 and the angle β3 between the third elastic piece 123 and the third metal elastic piece 13 are secondary deformation angles (supplementary to the main deformation angle). Therefore, in the present embodiment, as shown in FIG. 1, the angle β2 between the second elastic piece 122 and the first elastic piece 121 is greater than the angle β1 between the first elastic piece 121 and the first metal elastic piece 11, and less than the angle β3 between the third elastic piece 123 and the third metal elastic piece 13 (i.e. β1 <β2<β3).

In one implementation of the present embodiment, an angle β5 between the second elastic piece 122 and the third elastic piece 123 is equal to the angle β2 between the second elastic piece 122 and the first elastic piece 121.

Due to the angle β5 between the second elastic piece 122 and the third elastic piece 123 is the supplementary for the angle β2 between the second elastic piece 122 and the first elastic piece 121, in the present embodiment, the two angles (β2 and β5) are arranged to be equal.

In one implementation of the present embodiment, in order to ensure the supporting effect of the connecting structure of both the first elastic piece 121 and the first metal elastic piece 11 on the elastic deformation of the third metal elastic piece 13, the angle β1 between the first elastic piece 121 and the first metal elastic piece 11 may be designed at 75°.

In one implementation of the present embodiment, the angle β2 between the first elastic piece 121 and the second elastic piece 122 is a right angle, thereby reducing the reactive force generated by the connecting structure of both the first elastic piece 121 and the second elastic piece 122 on the connecting structure of both the first elastic piece 121 and the first metal elastic piece 11.

In one implementation of the present embodiment, the angle β3 between the third elastic piece 123 and the third metal elastic piece 13 is a secondary deformation angle. In order to ensure that the third metal elastic piece 13 can adapt to various sizes of the negative electrode of the battery, and to ensure a surface contact between the third metal elastic piece 13 and the various sizes of the negative electrode of the battery, the angle β3 between the third elastic piece 123 and the third metal elastic piece 13 is in a value range of 90°-150°. Among them, the angle β3 between the third elastic piece 123 and the third metal elastic piece 13 may be designed at 120°.

In one embodiment of the present disclosure, as shown in FIGs. 1 and 3, the spring elastic-piece electrically-conductive structure further includes a fourth metal elastic piece 14. One end of the fourth metal elastic piece 14 is connected to the second metal elastic piece 12, and another end of the fourth metal elastic piece 14 is relative to the third metal elastic piece 13 to be inclined toward the opening 3.

In the present embodiment, the fourth metal elastic piece 14 is relative to the third metal elastic piece 13 to form an inner buckle structure toward the opening 3, thereby forming a guiding angle between the fourth metal elastic piece 14 and the third metal elastic piece 13. The guiding angle not only guides the deformation of the third metal elastic piece 13, but also effectively prevents the third metal elastic piece 13 from scratching the surface of the battery.

In one implementation of the present embodiment, an angle β4 between the fourth elastic piece 14 and the third metal elastic piece 13 is in a value range of 90°-150°. Among them, the angle β4 between the fourth elastic piece 14 and the third metal elastic piece 13 may be designed at 120°.

The present disclosure further provides an electrical device, and the electrical device includes the above-mentioned spring elastic-piece electrically-conductive structure.

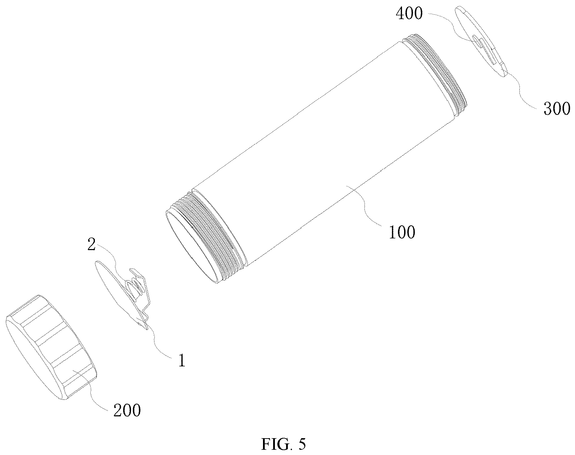

As shown in FIGs. 4 and 5, the electrical device further includes a metal accommodation cylinder 100, a tail cover 200, a circuit board 300, and a positive-electrode electrically-conductive component 400. The metal accommodation cylinder 100 is configured to accommodate a battery, and the battery is a cylindrical steel-shell lithium battery with larger volume. The tail cover 200 is detachably connected to one end of an axial direction of the metal accommodation cylinder 100. The spring elastic-piece electrically-conductive structure is arranged inside the tail cover 200 and electrically contacts or connects with the metal accommodation cylinder 100. The circuit board 300 is detachably arranged at another end of the axial direction of the metal accommodation cylinder 100 and electrically connected to the metal accommodation cylinder 100. The positive-electrode electrically-conductive component 400 is arranged on the circuit board 300 and arranged opposite to the present spring elastic-piece electrically-conductive structure.

In the spring elastic-piece electrically-conductive structure, the first metal elastic piece 11 fits and contacts with an end surface of an inner side of an axial direction of the tail cover 200, and an circular-arc end surface of the first metal elastic piece 11 electrically contacts or connects to a circular-arc inner-side wall of the metal accommodation cylinder 100, so that the tail cover 200 no longer participates in the electrically-conductive process and reduces one layer of contact resistance. Moreover, due to the longer metal wire and higher internal resistance of the spring 2, when conducting electricity, most of the current flows through the first metal elastic piece 11 with lower internal resistance, is conducted to flow to the metal accommodation cylinder 100 by the circular-arc end surface of the first metal elastic piece 11, then is conducted to flow sequentially to the circuit board 300 and the positive-electrode electrically-conductive component 400, and finally flows back to a positive electrode of a battery, forming a complete current circuit.

In one embodiment of the present disclosure, the spring 2 is a copper spring, the metal elastic piece 1 is an aluminum metal spring, and the metal accommodation cylinder 100 is an aluminum metal accommodation cylinder 100. It should be noted that as the spring 2 no longer participates in the electrically-conductive process, the current is not guided to flow from the copper spring 2 to the aluminum metal accommodation cylinder 100, but the current is guided to flow from the aluminum metal elastic piece 1 to the aluminum metal accommodation cylinder 100, avoiding the problem of forming an oxide layer on the copper-aluminum contact surface, increasing resistance, and creating safety hazard when the current is guided to flow from copper material to aluminum material.

It should be understood that the applications of the present disclosure are not limited to the above-mentioned embodiments. Those ordinary skilled in the art can make modifications or transformations according to the above description, and all of these modifications and transformations should fall within the protection scope of the claims attached to the present disclosure.

## Claims

1. A spring elastic-piece electrically-conductive structure, comprising:
a metal elastic piece; wherein one end of the metal elastic piece is bent relative to another end of the metal elastic piece to form an accommodation space having an opening; and
a spring, arranged inside the accommodation space; wherein two ends of the spring are connected to the metal elastic piece to support the opening.

2. The spring elastic-piece electrically-conductive structure according to claim 1, wherein the metal elastic piece comprises:
a first metal elastic piece;
a second metal elastic piece; wherein one end of the second metal elastic piece is connected to the first metal elastic piece, and is inclined relative to the first metal elastic piece; and
a third metal elastic piece; wherein one end of the third metal elastic piece is connected to one end of the second metal elastic piece away from the first metal elastic piece, another end of the third metal elastic piece is inclined relative to both the second metal elastic piece and the first metal elastic piece, and the opening is formed between the another end of the third metal elastic piece and the first metal elastic piece; the third metal elastic piece, the second metal elastic piece, and the first metal elastic piece are enclosed to form the accommodation space; the first metal elastic piece, the second metal elastic piece, and the third metal elastic piece are integrally formed.

3. The spring elastic-piece electrically-conductive structure according to claim 2, wherein the first metal elastic piece is a sector metal elastic piece.

4. The spring elastic-piece electrically-conductive structure according to claim 3, wherein a center of a circle of the sector metal elastic piece is located at a central axis of the spring to coincide.

5. The spring elastic-piece electrically-conductive structure according to claim 2, wherein an angle between the second metal elastic piece and the first metal elastic piece is an acute angle, and an angle between the second metal elastic piece and the third metal elastic piece is an obtuse angle.

6. The spring elastic-piece electrically-conductive structure according to claim 2, wherein the second metal elastic piece comprises a first elastic piece, a second elastic piece, and a third elastic piece sequentially connected to form a wave shape; the first elastic piece is connected to the first metal elastic piece, and the third elastic piece is connected to the third metal elastic piece; an angle between the second elastic piece and the first elastic piece is greater than an angle between the first elastic piece and the first metal elastic piece, and less than an angle between the third elastic piece and the third metal elastic piece.

7. The spring elastic-piece electrically-conductive structure according to claim 6, wherein the angle between the second elastic piece and the first elastic piece is a right angle.

8. The spring elastic-piece electrically-conductive structure according to claim 2, wherein the metal elastic piece further comprises:
a fourth metal elastic piece; wherein one end of the fourth metal elastic piece is connected to the third metal elastic piece, and another end of the fourth metal elastic piece is inclined toward the opening relative to the third metal elastic piece.

9. An electrical device, wherein the electrical device comprises the spring elastic-piece electrically-conductive structure according to any one of claims 1-8.

10. The electrical device according to claim 9, wherein the electrical device further comprises:
a metal accommodation cylinder, configured to accommodate a battery;
a tail cover, detachably connected to one end of an axial direction of the metal accommodation cylinder; wherein the spring elastic-piece electrically-conductive structure is arranged inside the tail cover, and electrically contacts or connects with the metal accommodation cylinder;
a circuit board, detachably arranged at another end of the axial direction of the metal accommodation cylinder, and electrically connected to the metal accommodation cylinder; and
a positive-electrode electrically-conductive component, arranged on the circuit board,
and arranged opposite to the spring elastic-piece electrically-conductive structure.
